# EUROPEAN PATENT APPLICATION

(11) **EP 1 220 392 A2**
(43) Date of publication of application: **03.07.2002**
(21) Application number: 01310474.0
(22) Date of filing: 14.12.2001
(51) Int. Cl.: H01S 5/183, H01S 5/04, H01S 5/026, H01S 3/0941, H01S 3/08

(54) **Lateral optical pumping of vertical cavity surface emitting laser**

(30) Priority: 15.12.2000 CA 2328637
(71) Applicant: Nortel Networks Limited, St. Laurent, Quebec H4S 2A9 (CA)
(72) Inventor: Clayton, Richard D., Kanata, Ontario K2L 2V5 (CA)
(74) Representative: Ertl, Nicholas Justin

(57) **Abstract**

An optically pumped monolithic VCSEL (vertical cavity surface emitting laser) architecture is disclosed. The laser structure comprises at least one signal VCSEL, at least one pump laser, and transition regions between the signal VCSELs and the pump lasers. The signal VCSEL is laterally optically pumped by the pump laser, which can be electrically or optically pumped. The signal VCSEL, the pump laser and the transition region all are monolithically integrated onto a common substrate. The signal VCSEL can be disposed outside or inside the pump laser cavity (extra-cavity or intra-cavity pumping). The cavity of the pump laser can takes various forms, such as a concave cavity, a confocal cavity, or a cylindrical or ellipsoidal form of cavity. Several signal VCSEL can be disposed in the focus or focal area of the cavity of the pump laser

## Description

The present invention relates to a vertical cavity surface emitting laser, and particularly relates to an improved vertical cavity surface emitting laser architecture being laterally optically pumped by a pump laser which is monolithically integrated with the vertical cavity surface emitting laser.

Vertical cavity surface emitting lasers (hereinafter, referred to as VCSEL) are considered desirable and are widely used for many optical communications applications. However, there have been some difficulties associated with the fabrication of high efficiency VCSELs For instance, electrical pumping of the gain region (active region) of VCSELs can he problematic due to the conflicting requirements of the reflective mirrors and the electrical injection process. Specifically, the mirrors typically need to have higher dielectric properties, while the current injection path should be of lower resistance electrically Therefore, the reflectivity of the mirrors compromises their conductances, and vice versa. Moreover, the electrical pumping of the VCSELs inevitably requires p and n dopants inside of the optical cavity, which means a reduction in the optical efficiency and, consequently, limitation of the output power

An alternative measure to overcome these problems is optical pumping technology, in which a separate pump laser is provided for pumping optically the VCSEL, which is called a signal laser with respect to the pump laser. This technology usually, however, requires separate production and alignment of the pump laser and the signal VCSEL. Furthermore, co-axial optical pumping of VCSELs is hampered by the constraints placed on the mirror filter functions and pump emission wavelengths. Further complication and expense arise in the hybrid assembly of such systems in achieving the required alignment of the pump and signal laser.

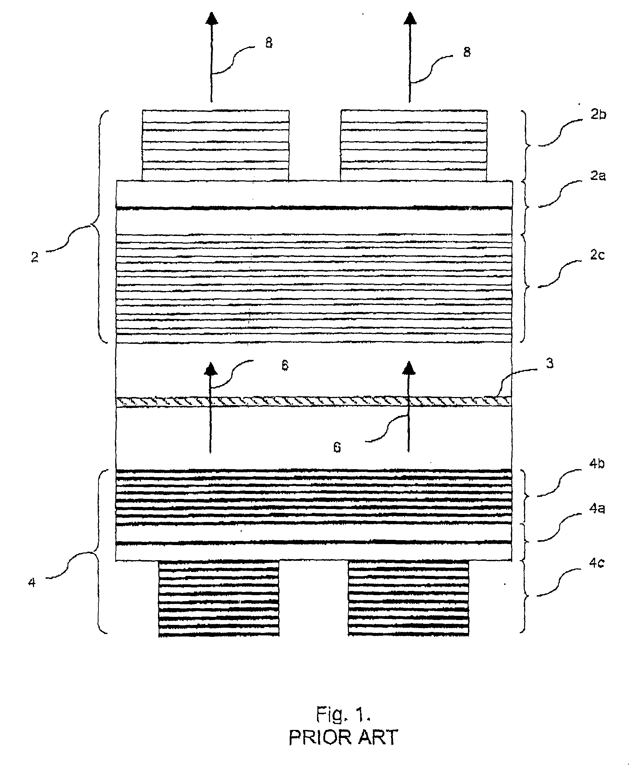

For example, U.S. Pat. No. 5,513,204 issued on April 30, 1996 discloses an optical pumped VCSEL configuration as shown in FIG. **1,** where a signal VCSEL **2** is vertically and coaxially aligned with a pump VCSEL **4.** The optically pumped signal VCSEL **2** consists of an active region **2a** interposed between a top mirror **2b** and a bottom mirror **2c** and emits a long wavelength radiation **8.** The electrically pumped pump VCSEL, likewise, consists of an active region **4a** between a pair of mirrors **4b, 4c** and emits a short wavelength radiation **6** as pumping light for the active region **2a** of the signal VCSEL **2** in fabricating This prior art configuration, co-axial alignment is unavoidable between the two VCSELs **2, 4,** and bonding **3** between them, such as optical transparent adhesive, wafer-fusion or metal-to-metal bonding is inevitably required All of these consequently lead to complicated manufacturing processes and cost increases Also, in operation, the pumping light **6** must pass through the bottom mirror **2c** of the signal VCSEL **2** in order for it to be transmitted to and pump the active region **2a** of the signal VCSEL **2.** Passing of light **6** through the mirror **2c** and the bonding **3** can lead to a reduction in the optical efficiency of the pumping light due to parasitic reflection, absorption, and so on. in addition, high brightness operation of the pump VCSEL **4** is more difficult than for edge emitting lasers, and separating the pump **4** from the signal VCSEL **2** enough to achieve sufficient thermal isolation may result in inefficient illumination of the signal VCSEL **2.**

In accordance with the present invention, there is provided an improved laser device, which comprises at least one signal vertical cavity surface emitting laser (a signal VCSEL) and at least one pump laser, wherein the signal VCSEL is laterally optically pumped by the pump laser. Each signal VCSEL has an active region, an upper mirror, and a lower mirror, and each pump laser has a cavity which includes at least one active region. Preferably, the pump laser is monolithically integrated with the signal VCSEL.

The VCSEL laser structure of the invention can be efficiently pumped by a pump laser, which allows greater flexibility in its selection from conventional laser architectures. The structure of the invention can be made compact, high powered and is easily fabricated.

Also, the laser device of the invention may further comprise a transition region between the signal VCSEL and the pump laser The transition region is monolithically integrated with the signal VCSEL and the pump laser as well, and is of higher energy bandgap than the pump laser emission energy. The transition region behaves as a waveguide for emission from the pump laser, as a barrier to the inter-diffusion of charge carriers between the pump laser and the signal VCSEL, and as a barrier for avoiding thermal crosstalk between the signal VCSEL and the pump laser.

in accordance with one feature of the invention, the signal VCSEL may be disposed inside or outside of the cavity of the pump laser, thereby carrying out an intra-cavity or extra-cavity pumping by the pump laser. Preferably, the pump lasers may be electrically or optically pumped, or a combination of electrically and optically pumped lasers.

In accordance with another feature of the invention, the cavity of the pump laser may be formed with plane mirrors Also, the pump laser may comprise a concave cavity formed with curved mirrors so that a pumping light from the pump laser can be focused onto an active region of the signal VCSEL. Preferably, the concave cavity may include a confocal cavity formed by mirrors having different curvatures from each other The cavity of the pump laser may include a convex cavity

In accordance with another feature of the invention, the cavity of the pump laser may have a cylindrical form. Also, the cavity may have the form of ellipsoid, or the form of partial ellipsoid, so that the signal VCSBL can be disposed at one focal point of the ellipsoid and the pump laser in the other focal point of the ellipsoid

According to the present invention, there is also provided an array of laser devices which comprises the laser device described above The array may be one- or two-dimensional Furthermore, according to the invention, there is provided an optoelectronic package which includes the laser device described above, where the laser device may be monolithically integrated with the package

According to the present invention, there is provided a method of operating a VCSEL, which comprises a step of pumping the VCSEL laterally optically with a light emitted from a pump laser The method further comprises a step of providing a monolithic integration of the VCSEL and the pump laser, Also, the method further comprises a step of providing a transition region between the VCSEL and the pump laser, in which a monolithic integration of the VCSEL, the pump laser, and the transition region may be provided.

According to other features of the invention, many possible resonator structures are possible to efficiently couple the pump laser to the signal VCSEL; the key attributes are good pumping efficiency, spatially localized pumping of the VCSEL, isolation of the heat and carriers of the pump laser from the signal VCSEL, low optical noise from the VCSEL. While a few of the most preferred configurations and methods for producing them will be presented, such as arrangements of nominally linear cavities and circular or related cavities, it should be understood that there are many other resonator structures and methods of achieving them without departing from the gist of the present invention. Therefore, the following description indicates desirable examples rather than the totality of approaches As is usually the case in semiconductor fabrication, the most desirable method for producing a component many be influenced by the equipment at hand: as such the examples are presented assuming a typical set of equipment for fabrication, and do not include exhaustive optimization for every manufacturing eventuality.

A further understanding of the other features, aspects, and advantages of the present inventian will be realized by reference to the following description, appended claims, and accompanying drawings.

The embodiments of the invention will now be described with reference to the accompanying drawings, in which;
Figure 1 is a schematic representation of a prior art configuration in which two VCSELs are coaxially aligned and physically bonded together;
Figure 2 is a schematic representation showing a conceptual configuration of the present invention;
Figure 3 is a schematic representation of a first embodiment with a pump laser monolithically integrated therewith in accordance with the present invention,
Figure 3a is a transverse sectional view of the Figure 3;
Figure 4 is a schematic representation of a second embodiment in accordance with the present invention, where a pump laser includes concaved mirrors.
Figure 5 is a schematic representation of a third embodiment, in which a pair of active regions are monolithically integrated therewith in accordance with the present invention,
Figure 5a is a transverse sectional view of the Figure 5, and

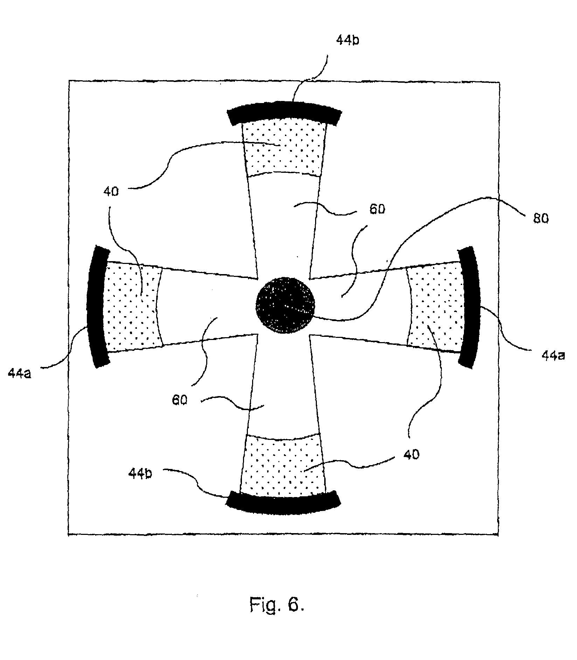

Figure 6a is a schematic representation of a fourth embodiment, in which a pair of pump lasers are monolithically integrated therewith in accordance with the present invention;
Figure 7 is a schematic representation of a fifth embodiment, in which a cylindrical shape of pump laser is monolithically integrated therewith around a signal VCSEL in accordance with the present invention;
Figure 7a is a vertical sectional view of the Figure 7;
Figure 8 is a schematic representation of a sixth embodiment, in which an elliptical shape of pump laser is monolithically integrated therewith around a signal VCSEL in accordance with the present invention;
Figure 8a is a vertical sectional view of the Figure 8;
Figure 9 is a schematic representation of a seventh embodiment, in which the monolithically integrated pump laser is configured for extra-cavity pumping of the VCSEL signal laser; and
Figure 9a is a transverse sectional view of the Figure 9

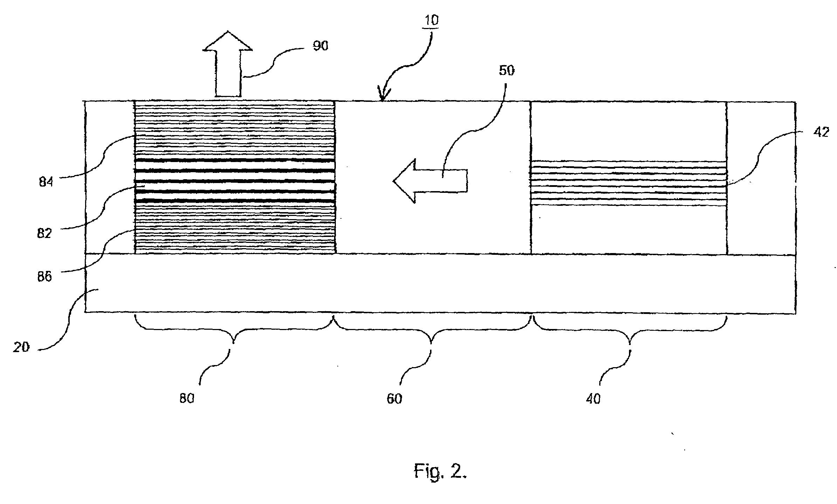

Before describing specific embodiments of the present invention, a basic concept of the present invention will be described with reference to FIG **2,** which shows a conceptual configuration of the optically pumped, vertical cavity surface emitting laser (VCSEL) having a lateral emission pump laser that is monolithically integrated onto a common substrate in accordance with the various principles of the invention.

Shown in FIG. **2** is a laser device **10** of The invention which comprises a pump laser **40** and a signal VCSEL **80,** both of which are monolithically integrated into one piece onto a common substrate **20.** The pump laser **40** may be an electrically or optically pumped, lateral emission laser, which constitutes an active region **42** sandwiched between two spacer or electric contacts, and reflective mirrors (not shown in FIG. **2**) as in conventional electrically or optically pumped lasers. As will be understood by those skilled in the art, the reflective mirrors may be selected from a variety of choices such as a reflective surface, Bragg reflectors, photonic lattices or their variations. The signal VCSEL **80** includes an active region **82** interposed between an upper mirror **84** and a lower mirror **86.** The terms "upper mirror" and "lower mirror" are well known in this laser device and do not require any particular spatial orientation of the device when in use. Likewise, these mirrors **84, 86** may be realized by many kinds of technologies, such as epitaxial layers, deposited dielectric layers, MEMS devices or any combinations of these or similar methods, as long as they are functional for the VCSEL operation. More specific configurations, functions and materials concerning the pump laser **40** and the signal VCSEL **80** will be described below in greater detail in conjunction with various embodiments of the invention.

Preferably, the laser device **10** may further comprise a transition region **60** between the pump laser **40** and the signal VCSEL **80,** with all of which it is monolithically integrated onto the substrate **20,** As will be further described below, the transition region **60** can play significant roles, like acting as a waveguide for pumping light, as a barrier to the diffusion of charge carriers from the gain region of the pump laser **40** or the signal VCSEL **80,** and as a barrier against thermal crosstalk between the device components. A significant feature is that all the above noted components **40, 60,** **80** are monolithically implemented onto the same common substrate **20** so that the laser device **10** can be made compact, more easily fabricated, and more reliable.

Briefly, in the operation of the device as shown in FIG. **2,** optical radiation is emitted laterally from the active region **42** of the pump laser **40** which may be electrically or optically pumped, and then laterally injected into the active region of the signal VCSEL **80.** The pump laser radiation acts as a pumping light **50** for the signal VCSEL **80.** At this time, the transition region **60** acrs as a waveguide for the pumping light **50.** Also, it avoids the heat crosstalk between the pump laser **40** and the signal VCSEL **80** and the diffusion of charge carriers out of the signal VCSEL **80** and the pump laser **40,** leading to enhancement in its efficiency Finally, a device output **90** is generated from the signal VCSEL **80.** More detailed operation of both intra-pump-cavity and extra-pump-cavity will be described below with reference to various embodiments of the invention.

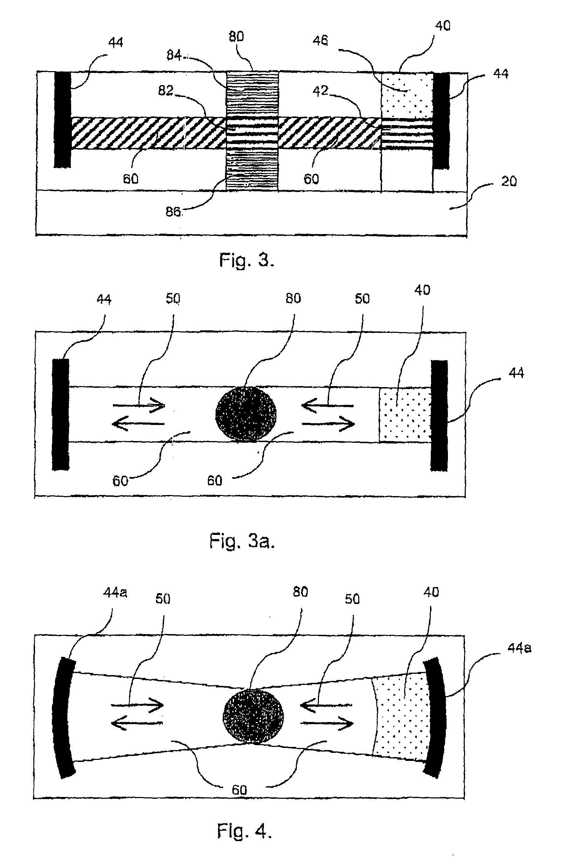

In FIGs. **3** and **3a,** a first specific embodiment of a monolithically integrated VCSEL is shown, in which a signal VCSEL **80** and a pump laser **40** are provided on a common substrate **20,** and a pair of reflective mirrors **44** for the pump laser are provided at both sides of the signal VCSEL **80** to achieve intra-pump-cavity pumping of the VCSEL **80.** Two transition regions **60** are formed between the mirrors **44** as illustrated in FIGs. **3** and **3a** Accordingly, the active region **82** of the signal VCSEL **80,** together with the transition regions **60** and the active region **42** of the pump laser, act as a waveguide for the emission from the pump laser **40,** i.e., as a waveguide for the pumping light **50** as shown in FIG. **3a.** These components **42, 60,** and 82 may be referred to as a "waveguide region" for convenience of the description.

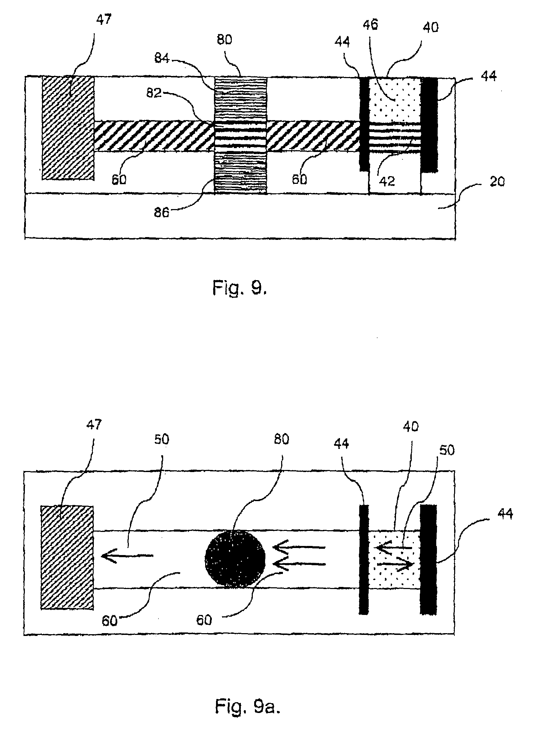

In the embodiment of FIGs **3** and **3a,** the active region **42** of the pump laser **40,** which may be electrically or optically pumped, emits radiation. The radiation is amplified through stimulated emission while in the waveguide region **42,** and then travels between the pair of mirrors **44** via the waveguide regions **42, 60, 82.** While traveling between the pair of mirrors **44** as the pumping light **50,** the radiation is partially absorbed by the active region **82** of the signal VCSEL **80.** When sufficient pump radiation is absorbed in the VCSEL active region **82,** the VCSEL **80** reaches the threshold condition and begins surface normal emission at the VCSEL wavelength as the device output **90** in FIG. **2.** The radiation from the pump laser **40** must be of higher energy than that of the signal VCSEL **80** and, therefore, must be chosen for the optimum offset, depending on the application and fabrication technology choices. The pump laser **40** must provide the pumping light 50 to a suitable area of the appropriately configured VCSEL gain region **82** to ensure single transverse mode operation of the VCSEL **80** While the embodiment shown in FIGs. **3** and **3a** carries out an intra-cavity pumping where the signal VCSEL **80** is disposed inside of the pump laser **40** cavity, as shown in FIGs. **9** and **9a,** the signal VCSEL **80** may be disposed outside of the pump laser cavity so that an extra-cavity pumping can be carried out Further details of the extra-cavity pumping will be described hereafter.

As those skilled in the art will understand, the various components of the device need to be sufficiently compatible to allow the monolithic integration, while being differentiated by their required functions. For example, the signal VCSEL **80** should have the layers designed for low optical losses, since the single pass gain is not large, and so, for example, should not have substantial p dopant concentration in the optical path, while the pump laser **40** requires the p doping for efficient electrical pumping. Optimum pump laser efficiency can be achieved when the active region **82** of the signal VCSEL **80** acts as a proper waveguide for the pumping light **50.** The transition waveguide regions **60** and their interface with the VCSEL **80** should have low absorption and scattering losses for the pumping light (radiation) **50** and VCSEL radiation. These aspects of the transition region **60** can be realized through various processing methods, such as a conceptually straightforward multistage epitaxial growth of specifically designed layers, while other methods could involve selective bandgap modification through, for example, quantum well intermixing processes and p dopant diffusion, or various combinations of such processes.

Also, effective operation of the invention requires several design considerations, including optimizing the reflective mirror stacks **84, 86** for the signal VCSEL **80,** positioning the active region **82** of the signal VCSEL at the optimum position relative to the standing wave resonating in the VCSEL cavity, ensuring the transition waveguide region **60** does not introduce substantial loss to the VCSEL mode or to the pump radiation, ensuring the radiation energy of the pump laser **40** effectively pumps the signal VCSEL **80,** and producing a simple stable lateral pump laser cavity. As will be understood by those skilled in the art, these requirements for embodying the invention can be met by selecting appropriately from many conventional laser fabrication technologies and materials. Also, any conventional laser processing, such as the selective etching and epitaxial regrowth technology, can be used in order to fabricate the monolithic lateral optical pumping VCSEL of the invention.

In Fig **4,** a second embodiment of the monolithic optical pump VCSEL is shown, in which all the portions of it are the same as the first embodiment illustrated in FIG. **3** and **3a,** with exception of the shape of reflective mirrors for the pump laser **40** As seen in FIG. **4,** the mirrors **44a** are concaved toward the active region **82** of the signal VCSEL **80** so that the pumping light **50** can be effectively concentrated onto the active region of the signal VCSEL **80** so as to pump it efficiently The operation is similar to that of the first embodiment, except for the efficient focusing of pumping light onto the signal VCSEL to help control lateral modes of both the signal and pump lasers. The two mirrors **44a** need not have the same radius of curvature the requirement is that the foci of the two mirrors be placed relative to each other (nominally coincident) to provide an efficient, low intensity noise pump laser. Tolerances and tradeoffs in the designed position of the mirrors and foci are available from various texts on laser resonator design and are well known to laser designers.

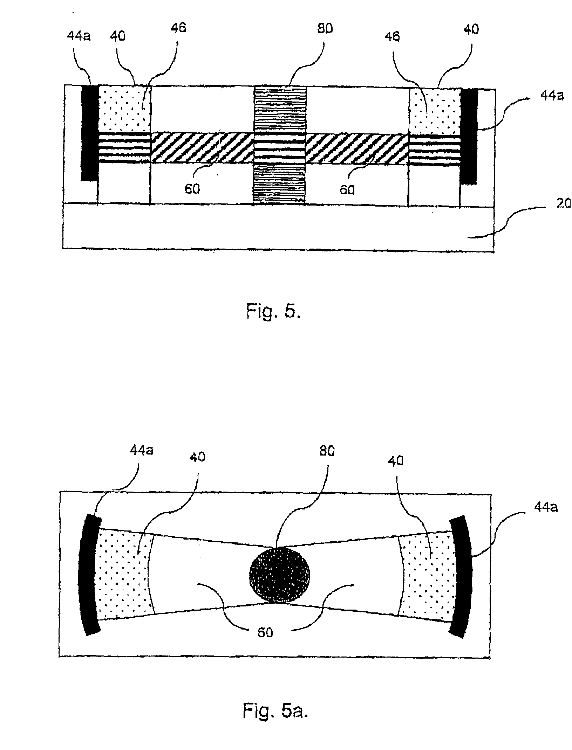

Fig. **5** and **5a** illustrate a third embodiment of monolithic optical pump VCSEL configuration. In this embodiment, the pump lasers **40** is fabricated with two active regions **42** monolithically provided onto the same substrate **20** together with a signal VCSEL **80** and transition regions **60,** and the remaining portions are similar to the first and second embodiments as shown in FIG. **3** and **3a,** and FIG, **4** respectively, As depicted in FIG. **5a,** the signal VCSEL **80** is placed at the center of the symmetric pump laser cavity, within the mirrors **44a.** As noted above, however, the signal VCSEL **80** may be disposed outside of the cavity of the pump laser **40** so that an extra-cavity pumping can be accomplished by the pump laser. Similarly to the second embodiment of FIG **4,** the mirrors **44a** may be concaved toward the active region **82** of the signal laser **80** for the same reason. In this embodiment, however, the two mirrors **44a** may have different radius of curvatures from each other, so that two signal VCSELs may be disposed at each focal point of the curved mirrors Namely, a confocal cavity of the pump laser may be achieved. Also, it is possible that more than two signal VCSELs are disposed in the focal area of the concave or confocal cavity of the pump laser. The other operational features of this embodiment are similar to the previous embodiments, except that the signal VCSEL **80** will be more efficiently and powerfully pumped due to the action of the two pump gain regions **42.**

More than one pump laser may be provided so that more controlled and efficient pumping and consequently a more powerful output of the signal VCSEL can be realized. For example, FIG, **6** depicts an embodiment in which a pair of pump lasers **40** are provided, where the pump lasers **40** may be electrically or optically pumped, or a combination of electrically or optically pumped lasers. Likewise, the details of each component region and their operations are similar to or the same as those of the previous embodiments, for example, an extra-cavity and/or intra-cavity pumping may be carried out by the pump lasers, and the cavity of pump laser may include a concave cavity or a confocal cavity.

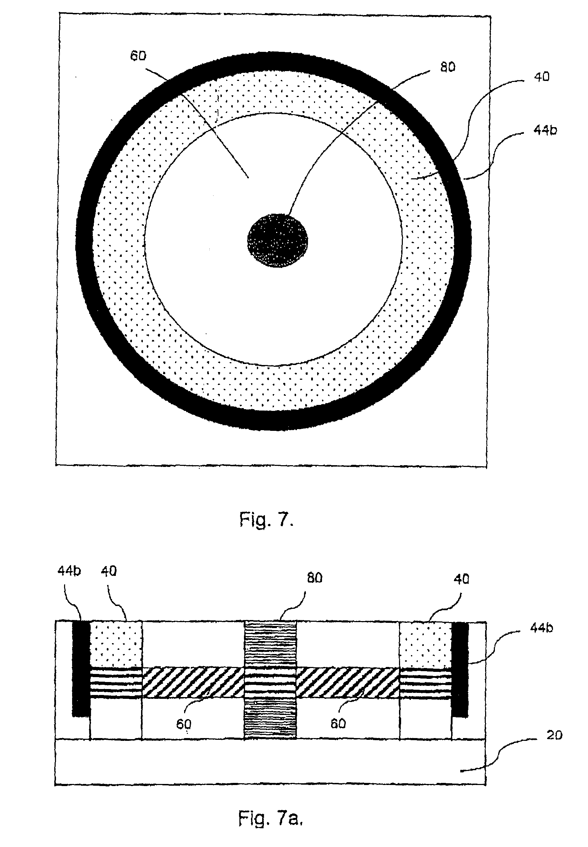

A mirror of cylindrical shape may be provided around the signal VCSEL so as to pump it more efficiently. As is illustrated in FIG. **7,** this embodiment includes a cylindrically shaped pump laser **40,** a cylindrically shaped mirror **44b** provided around the cylindrical pump laser, and a signal VCSEL **80** disposed at the center of the mirror **44b,** so that more efficient and intensive pumping of the signal VCSEL **80** can be realized. Likewise, the area between the signal VCSEL **80** and the cylindrical pump laser **40** serves to function as a transition region **60** which is also monolithically integrated with the signal VCSEL **80** and the reflective mirror **44b** onto the substrate **20,** as is illustrated in FIG. **7a** which is a vertical sectional view of FIG. **7**. As will be understood by those skilled in this art, it is desirable that the signal VCSEL **80,** the pump laser **40,** and the transition region **60** is concentric with one another for more effective operation of the device. The other operational features of this embodiment will be similar to the previous embodiments, for example, except that the signal VCSEL **80** will be more efficiently and intensively pumped due to the circular shape of pump laser **40.** It is important to note that care in the design of the pump resonator is required to ensure the appropriate operating spatial mode of the pump laser is achieved An example would be a grating based mirror which would not support non-radial modes, or mode selective features for cavities formed with conventional mirrors.

In the embodiment shown in FIGs **7** and **7a,** the pump laser may take a ellipsoidal form to make a confocal cavity so that two signal lasers can be disposed at each focus. As noted above, more than two signal VCSELs may be disposed in the focal or confocal area of the cavity of the pump laser.

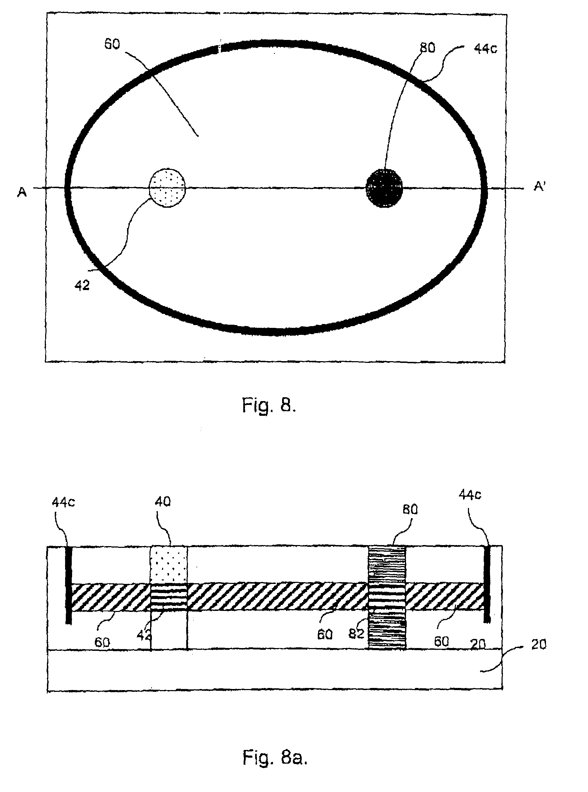

A mirror of elliptical shape may be provided around the signal VCSEL as an alternative pumping configuration. As is illustrated in FIG. **8,** this embodiment includes an elliptically shaped pump laser **40,** constructed from an elliptically shaped mirror **44c** provided around the pump laser active region **42** and signal VCSEL **80,** The pump and signal lasers are disposed at the foci of the elliptical cavity of the pump laser, which is defined by the elliptically shaped mirror **44b,** so that more efficient and intensive pumping of the signal VCSEL **80** can be realised Likewise, the area between the signal VCSEL **80** and the pump gain region **40** serves to function as a transition region **60** which is also monolithically integrated with the signal VCSEL **80** and the reflective mirror **44c** onto the substrate **20,** as is illustrated in FIG. **8a** which is a vertical sectional view of FIG. **8.** The operation of this embodiment will be similar to the previous embodiments, and the pump gain regions **42** may be disposed as shown or more similarly to the case of FIG. **7.**

As noted above, the same basic structures may be applied to extra-pump-cavity pumping as well. Extra-cavity pumping requires the signal VCSEL be placed outside the feedback cavity of the pump laser, allowing the pump laser to oscillate in isolation. The output radiation from the pump laser is then coupled to the VCSEL structure. The above referenced structures can be modified to provide extra-cavity pumping of the VCSEL. The key changes involve ensuring the residual pump light from one pump source does not destabilize the other pump sources. An example of an extra-pump-cavity configuration is shown in FIG. **9** In such cases the signal VCSEL **80** is placed outside the pump laser resonator formed by the mirrors **44.** An additional feature is the optical termination region **47,** which is desired to ensure spurious reflections do not disrupt the operation of the pump laser **40.** This region can be absorptive, reflective or scattering, the primary objective being to adequately reduce light returning to the pump laser **40.** While the extra-pump-cavity pumping configuration is advantageous in establishing mode control of the pump source, it does not provide the same efficiency in use of pump photons.

While the present invention has been described with reference to several specific embodiments, the description is illustrative of the invention and is not to be construed as limiting the invention. Terms used herein such as "vertical" in relation to the signal VCSEL and "upper" and "lower" in relation to the mirrors are terms well known in this art and do not limit the invention to any particular orientation when in use Various modification may occur to those skilled in the art without departing from the true spirit and scope of the invention as defined by the appended claims.

For example, according to the present invention, a one- or two- dimensional array of the VCSEL laser described above may be provided, which is included in the scope of the present invention. Any optoelectronic package or application comprising the laser device described above may be provided, which is also included in the scope of the invention. As will be understood by those skilled in the art, the laser device of the package or application may be monolithically integrated into the package or application itself.

Furthermore, according to the present invention, there may be provided a method of operating a VCSEL, which comprises a step of pumping the VCSEL laterally with a light emitted from a pump laser. The method further comprises a step of providing a monolithic integration of the VCSEL and the pump laser. Also, the method further comprises a step of providing a transition region between the VCSEL and the pump laser, in which a monolithic integration of the VCSEL, the pump laser, and the transition region may be provided.

## Claims

1. A laser device comprising:
a vertical cavity surface emitting laser (a signal VCSEL); and
a pump laser comprising a cavity, which includes at least one active region, wherein the signal VCSEL is laterally optically pumped by the pump laser.

2. A laser device as claimed in claim 1, wherein the pump laser is monolithically integrated with the signal VCSEL.

3. A laser device as claimed in claim 1 or 2, further comprising a transition region between the signal VCSEL and the pump laser.

4. A laser device as claimed in claim 3, wherein the signal VCSEL, the pump laser, and the transition region are monolithically integrated with one another.

5. A laser device as claimed in any preceding claim, wherein the signal VCSEL is disposed inside the cavity of the pump laser.

6. A laser device as claimed in any one of claims 1 to 4, wherein the signal VCSEL is disposed outside the cavity of the pump laser.

7. A laser device as claimed in any preceding claim, wherein the cavity of the pump laser includes a cavity having a cylindrical form.

8. A laser device as claimed in any one of claims 1 to 6, wherein the cavity of the pump laser includes a cavity having the form of an ellipsoid.

9. A laser device as claimed in claim 8, wherein the signal VCSEL is disposed at one focal point of the ellipsoid.

10. A laser device as claimed in claim 9, wherein the active region of the pump laser is disposed at the other focal point of the ellipsoid.

11. A laser device as claimed in any one of claims 1 to 6, wherein the cavity of the pump laser includes a cavity having the form of a portion of an ellipsoid which is capable of forming a resonator.

12. A laser device as claimed in claim 11, wherein the signal VCSEL is disposed at one focal point of the ellipsoid.

13. A laser device as claimed in claim 12, wherein the active region of the pump laser is disposed at the other focal point of the ellipsoid.

14. A laser device as claimed in any preceding claim, comprising a plurality of pump lasers.

15. A laser device as claimed in any one of claims 1 to 6, wherein the cavity of the pump laser is formed with a plane mirror.

16. A laser device as claimed in any one of claims 1 to 6, wherein the cavity of the pump laser includes a concave cavity formed with a curved mirror.

17. A laser device as claimed in claims 16, wherein the concave cavity includes a confocal cavity.

18. A laser device as claimed in any one of claims 1 to 6, wherein the cavity of the pump laser is formed with a plane mirror and a curved mirror.

19. A laser device as claimed in claims 16, 17 or 18, wherein the curved mirror is arranged so that a pumping light from the pump laser is focused onto an active region of the signal VCSEL.

20. A laser device as claimed in any one of claims 1 to 6, wherein the cavity of the pump laser includes a convex cavity.

21. A laser device as claimed in any preceding claim, wherein the pump laser is electrically pumped.

22. A laser device as claimed in any one of claims 1 to 20, wherein the pump laser is optically pumped.

23. A laser device as claimed in any one of claims 1 to 20, wherein the pump laser is a combination of electrically and optically pumped lasers.

24. A laser device as claimed in claim3 or 4, wherein the transition region is of higher energy bandgap than the pump laser emission energy.

25. A laser device as claimed in claim 3 or 4, wherein the transition region and the active region of the signal VCSEL define a waveguide for emission of the pump laser.

26. A laser device as claimed in claims 3 or 4, wherein the transition region defines a barrier to the inter-diffusion of charge carriers between the pump laser and the signal VCSEL.

27. A laser device as claimed in claims 3 or 4, wherein the transition region defines a barrier for avoiding thermal crosstalk between the signal VCSEL and the pump laser.

28. An optoelectronic package comprising a laser device as claimed in any preceding claim.

29. An array of laser devices as claimed in any one of claims 1 to 27.

30. An array of laser devices as claimed in claim 29, wherein the array of laser devices is one-dimensional.

31. An array of laser devices as claimed in claim 29, wherein the array of laser devices is two-dimensional.

32. An optoelectronic package comprising an array of laser devices as claimed in claim 29, 30 or 31.

33. A method of operating a VCSEL comprising the step of pumping the VCSEL laterally optically with light emitted from a pump laser.

34. A method as claimed in claim 33, further comprising the step of providing a monolithic integration of the VCSEL and the pump laser.

35. A method as claimed in claim 33 or 34, further comprising the step of providing a transition region between the VCSEL and the pump laser.

36. A method as claimed in claim 35, further comprising the step of the step of providing a monolithic integration of the VCSEL, the pump laser and the transition region.
